# EUROPEAN PATENT APPLICATION

(11) **EP 2 679 894 A1**
(43) Date of publication of application: **01.01.2014**
(21) Application number: 12184811.3
(22) Date of filing: 18.09.2012
(51) Int. Cl.: F21V 27/02, F21V 31/04, F21S 8/00, F21V 15/01, H01L 51/00, F21S 8/02, F21Y 105/00, F21Y 101/00

(54) **Luminaire**

(30) Priority: 29.06.2012 JP 2012147786
(71) Applicant: Toshiba Lighting & Technology Corporation, Yokosuka-shi Kanagawa 237-8510 (JP)
(72) Inventor: Hayashi, Junya, Kanagawa, 237-8510 (JP)
(74) Representative: Willquist, Sofia Ellinor

(57) **Abstract**

A luminaire (100) includes a light-emitting unit (2) having an organic light-emitting diode, a control unit (3) provided on a side opposite a light emitting surface (2f) of the light-emitting unit (2) and configured to supply power to the light-emitting unit (2), and a housing (1) configured to cover the light-emitting unit (2) and the control unit (3) integrally.

## Description

### FIELD

Embodiments described herein relate generally to a luminaire.

### BACKGROUND

There is a luminaire using light-emitting diodes as light sources.

In the luminaire using the light-emitting diodes, plane illumination is achieved by diffusing light from the light-emitting diodes by a light guide panel.

However, in the case of the luminaire using the light-emitting diodes, it is necessary to arrange a number of light-emitting diodes and provide a light guide panel on an irradiating side of the number of light-emitting diodes. Therefore, there is a problem of increase in projecting dimension from a surface of a building material.

In this case, if the light guide panel or the like is provided on the surface of the building material to guide light from the light-emitting diodes embedded within the building material to the light guide panel, the projecting dimension from the surface of the building material may be reduced.

However, with the configuration in which the light is guided from the light-emitting diodes embedded within the building material to the light guide panel, there arises a problem that areas which are not lit may be generated on the light guide panel on the surface of the building material.

In other words, in the luminaire using the light-emitting diodes, the luminaire having a large light-emitting surface is hardly obtained.

### DESCRIPTION OF THE DRAWINGS

Fig. 1A is a schematic partial cross-sectional view illustrating a luminaire 100 according to a first embodiment;
Fig. 1B is a view taken along the line A-A in Fig. 1A;
Fig. 2 is a schematic cross-sectional view illustrating a light emitting element 2;
Fig. 3 is a schematic partial cross-sectional view illustrating about installation of the luminaire 100 according to the first embodiment; and
Fig. 4 is a schematic partial cross-sectional view illustrating about the installation of the luminaire 100 according to a second embodiment.

### DETAILED DESCRIPTION

A first exemplary embodiment provides a luminaire including a light-emitting unit having an organic light-emitting diode, a control unit provided on a side opposite a light-emitting surface of the light-emitting unit and configured to supply power to the light-emitting unit, and a housing configured to cover the light-emitting unit and the control unit integrally.

Accordingly, the light-emitting unit having the organic light-emitting diode and the control unit provided on the side opposite the light-emitting surface of the light-emitting unit are integrated.

Therefore, the luminaire having the thin light-emitting unit and the large light-emitting surface is provided.

A second exemplary embodiment provides the luminaire in which the light-emitting unit is larger than an opening of a hole provided in a building material.

Accordingly, even though the light-emitting surface is larger than the opening of the hole provided on the building material, generation of an area which is not lit on the light-emitting surface may be inhibited.

A third exemplary embodiment provides the luminaire in which the housing is provided in the interior of the hole provided in the building material.

Accordingly, the projecting dimension from the surface of the building material is small.

A fourth exemplary embodiment provides the luminaire in which the housing seals up the light-emitting unit and the control unit.

Accordingly, the light-emitting unit and the control unit are sealed up by the housing.

Consequently, improvement of waterproof performance is achieved.

A fifth exemplary embodiment provides the luminaire in which the housing includes a hole that allows wiring connected to the control unit to be drawn out, and resin is filled between the hole that allows the wiring to be drawn out and the wiring.

Accordingly, further improvement of the waterproof performance is achieved.

A sixth exemplary embodiment provides the luminaire in which the housing includes a retaining portion configured to retain the light-emitting unit and an enclosure configured to accommodate the control unit.

Accordingly, a compact luminaire is provided.

A seventh exemplary embodiment provides the luminaire in which the retaining portion includes a first depression having an opening, and the light-emitting unit is retained in the interior of the first depression.

Accordingly, reduction in thickness of a portion configured to retain the light-emitting unit is achieved.

An eighth exemplary embodiment provides the luminaire in which the enclosure includes a second depression configured to accommodate the control unit, and the second depression has an opening at a bottom surface of the first depression.

Accordingly, wiring between the light-emitting unit and the control unit is facilitated.

A ninth exemplary embodiment provides the luminaire in which the control unit includes a substrate, a circuit component mounted on the substrate, a sealing portion configured to seal the circuit component mounted on the substrate.

Accordingly, further improvement of the waterproof performance is achieved.

A tenth exemplary embodiment provides the luminaire in which the control unit is retained in the interior of the housing by the sealing portion.

Accordingly, waterproofing and retaining of the control unit is achieved by the sealing portion.

An eleventh exemplary embodiment provides the luminaire in which the control unit is waterproofed by the sealing portion.

Accordingly, the luminaire which is usable in an environment in which waterproof specification is required is provided.

A twelfth exemplary embodiment provides the luminaire in which the light-emitting unit includes a first electrode layer having translucency, a second electrode layer having a reflectivity, and a light-emitting layer provided between the first electrode layer and the second electrode layer and including an organic light-emitting material.

Accordingly, the thickness of the light-emitting unit may be reduced, and size of the light emitting surface may be increased.

A thirteenth exemplary embodiment provides the luminaire further including a mounting fixture body provided so as to surround the hole provided in the building material and a mounting frame to be mounted on the mounting fixture body. Then, the light-emitting unit is retained between the mounting fixture body and the mounting frame.

Accordingly, mounting into the hole provided in the building material is facilitated.

A fourteenth exemplary embodiment provides the luminaire further including a cover provided on the side of the light-emitting surface of the light-emitting unit.

Accordingly, protection of the light-emitting unit is achieved.

A fifteenth exemplary embodiment provides the luminaire further including a box embedded in the building material and opening to the surface of the building material.

Accordingly, protection of a connecting portion of the wiring in the interior of the hole provided in the building material is achieved.

Referring now to the drawings, an embodiment will be described. In the drawings, the same components are designated by the same reference numerals and detailed description will be omitted as needed.

### [First Embodiment]

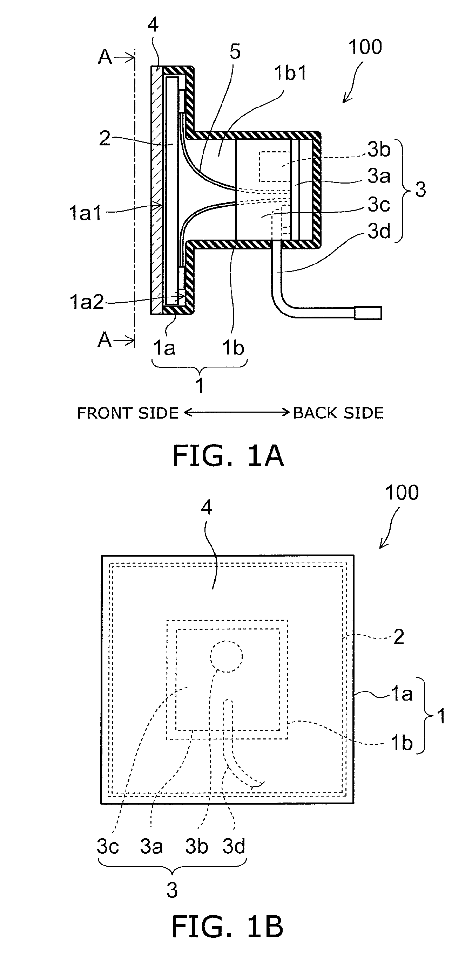

Fig. 1A and 1B are schematic drawings illustrating a luminaire 100 according to a first embodiment.

Fig. 1A is a schematic partial cross-sectional view, and Fig. 1B is a view taken along the line A-A in Fig. 1A.

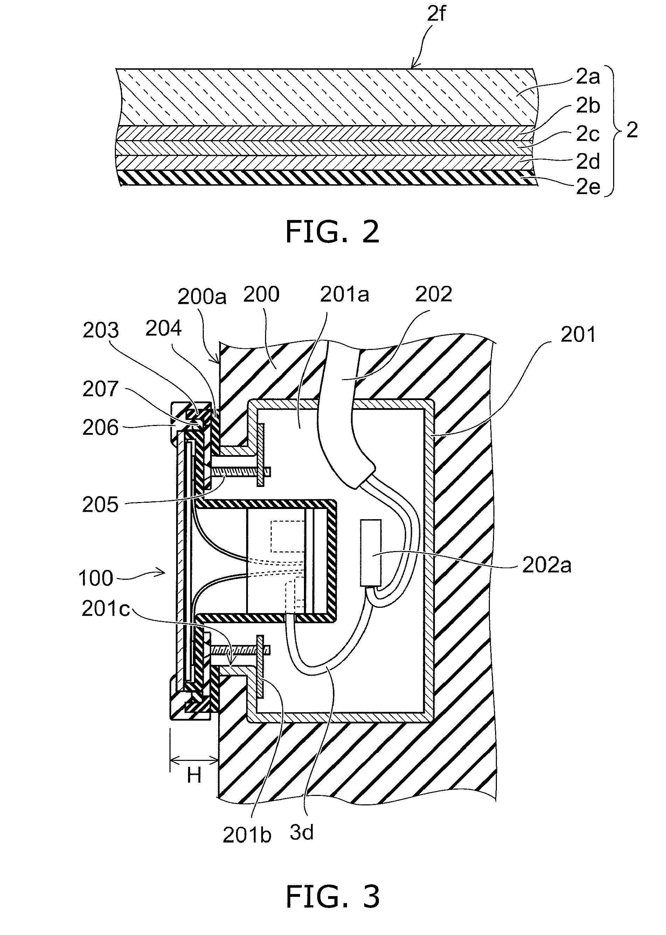

Fig. 2 is a schematic cross-sectional view illustrating a light-emitting unit 2.

As illustrated in Fig. 1A and Fig. 1B, the luminaire 100 includes a housing 1, the light-emitting unit 2, a control unit 3, and a cover 4.

The housing 1 is formed of an insulating material such as a resin material.

The housing 1 integrally covers the light-emitting unit 2 and the control unit 3.

The housing 1 seals up the light-emitting unit 2 and the control unit 3.

As described later, the housing 1 is provided in the interior of a hole provided in a building material 200 (for example, in a space 201a of the switch box 201).

The housing 1 includes a retaining portion 1a configured to retain the light-emitting unit 2 and an enclosure 1b configured to accommodate the control unit 3.

The retaining portion 1a includes a depression 1a1 (corresponding to an example of a first depression) having an opening on the front side of the luminaire 100, and retains the light-emitting unit 2 in the interior of the depression 1a1.

A method of retaining the light-emitting unit 2 is not specifically limited, and holding an end portion on the light-emitting unit 2 tightly from both sides, tightening with a screw or the like and bonding with an adhesive agent are also included.

The enclosure 1b is provided on the side opposite the side where the light-emitting unit 2 of the retaining portion 1a is retained.

The enclosure 1b includes a depression 1b1 (corresponding to an example of a second depression) configured to accommodate the control unit 3, and the depression 1b1 opens to a bottom surface 1a2 of the depression 1a1.

The control unit 3 is accommodated in the interior of the depression 1b1.

A hole is provided in a side wall of the enclosure 1b on the bottom surface side so as to allow a wiring 3d connected to the control unit 3, described later, to be drawn out of the enclosure 1b via the hole.

A gap between the hole provided in the enclosure 1b and the wiring 3d is filled with a silicone resin or the like to secure waterproof properties.

In other words, the housing 1 includes a hole that allows the wiring 3d connected to the control unit 3 to be drawn out. A gap between the hole that allows the wiring 3d to be drawn out and the wiring 3d is filled with a resin.

The light-emitting unit 2 has a plate shape and may have an organic light-emitting diode (OLED) as a self-luminous element.

As described later, the light-emitting unit 2 may be configured to be larger than the opening of the hole provided in the building material 200.

For example, if the switch box 201 described later or the like is provided, the light-emitting unit 2 may be configured to be larger than the opening of the switch box 201 or the like.

If the switch box 201 is not provided, the light-emitting unit 2 may be configured to be larger than the opening of the hole provided on a surface 200a of the building material 200.

In other words, the light-emitting unit 2 may be configured to be larger than the opening of the hole provided in the building material 200 for mounting the luminaire 100.

The light-emitting unit 2 and the control unit 3 are connected via the wiring 5.

As illustrated in Fig. 2, the light-emitting unit 2 is provided with a substrate 2a, an electrode layer 2b (corresponding to an example of a first electrode layer), a light-emitting layer 2c, an electrode layer 2d (corresponding to an example of a second electrode layer) and an insulating layer 2e.

The substrate 2a may be formed using a material having translucency.

The substrate 2a may be formed by using alkali-free glass which does not contain alkaline component such as sodium or potassium.

A surface of the substrate 2a opposite the side where the electrode layer 2b is provided corresponds to a light emitting surface 2f.

The electrode layer 2b is provided on a surface opposite the light emitting surface 2f of the substrate 2a.

The electrode layer 2b may have an electrode (anode) for hole-injection with respect to the light-emitting layer 2c.

The electrode layer 2b also has a function to transmit light radiated from the light-emitting layer 2c to the substrate 2a side.

The electrode layer 2b may be formed by using a material having conductivity and translucency such as ITO (Indium Tin Oxide).

The light-emitting layer 2c is provided on the side opposite the side where the substrate 2a of the electrode layer 2b is provided.

The light-emitting layer 2c may include an organic light-emitting material.

For example, the light-emitting layer 2c may be formed by laminating a hole transport layer containing 4,4'-bis[N-(2-naphthyl)-N-phenyl-amino]biphenyl (generally referred to as α-NPD), an organic light-emitting layer containing tris(8-hydroxyquinolinato)aluminum complex (generally referred to as Alq3), and an electron injection layer containing lithium fluoride (LiF).

However, the material and the configuration of the light-emitting layer 2c are not limited to those illustrated, and various modifications may be made as needed.

For example, the light-emitting layer 2c may have a single layer structure formed only of the organic light-emitting layer, or may have a multilayer structure further including a hole injection layer containing phthalocyanine, or an electron transport layer containing fluorene derivative. Also, the light-emitting layer 2c may have a multi-photo emission (MPE) structure in which a plurality of organic light-emitting layers are connected in series via a charge generation layer (GCL) containing HAT(CN)6.

The electrode layer 2d is provided on the side opposite the side where the electrode layer 2b of the light-emitting layer 2c is provided. The electrode layer 2d may have an electrode (cathode) for electron-injection with respect to the light-emitting unit 2.

The electrode layer 2d may be formed by using a material having conductivity and light reflectivity such as aluminum.

The insulating layer 2e is provided on the side opposite the side where the light-emitting layer 2c of the electrode layer 2d is provided. The insulating layer 2e may be formed using an insulating material such as resin, for example.

Here, if the electrode layer 2d and the insulating layer 2e are formed from a material transmitting light, the control unit 3 or the like located on the back side of the light-emitting unit 2 is seen through when the luminaire 100 is turned OFF.

Therefore, at least either one of the electrode layer 2d or the insulating layer 2e preferably has light blocking effects.

In this case by forming the electrode layer 2d of a metal such as aluminum, the control unit 3 or the like located on the back side of the light-emitting unit 2 is prevented from being seen through when the luminaire 100 is turned OFF.

The control unit 3 is provided on the side opposite the light emitting surface 2f of the light-emitting unit 2.

The control unit 3 is provided so as to be located in the vicinity of the center of the light-emitting unit 2.

The control unit 3 is smaller than the opening dimension of the switch box 201 or the like described later.

The control unit 3 is provided with a substrate 3a, a circuit component 3b, a sealing portion 3c, and the wiring 3d.

The control unit 3 may be configured to have a lighting circuit configured to supply power to the light-emitting unit 2.

For example, the substrate 3a may be formed with a wiring pattern on a surface of a base material using an epoxy resin or ceramics.

The circuit component 3b is mounted on the substrate 3a.

The circuit component 3b may be, for example, a component which configures the lighting circuit.

If the circuit component 3b is a component which constitutes the lighting circuit, for example, a diode configured to perform full-wave rectification on an AC current, a capacitor configured to smooth a rectified pulsation voltage, and a switching element may be applied.

However, the circuit component 3b is not limited to those exemplified above, and may be any component which constitutes the lighting circuit.

The control unit 3 may further have a dimming circuit.

In this case, the circuit component 3b further includes a component which constitutes the diming circuit.

The sealing portion 3c seals the circuit component 3b mounted on the substrate 3a.

The sealing portion 3c may be formed by filling with a silicone resin.

In this case, the control unit 3 is retained in interior of the housing 1 by the sealing portion 3c.

The sealing portion 3c is provided for securing electrical insulating properties of the circuit component 3b mounted on the substrate 3a.

In addition, by forming the sealing portion 3c by filling a resin or the like, waterproof properties are secured.

In other words, the control unit 3 is waterproofed by the sealing portion 3c.

The wiring 3d is connected at one end thereof to a terminal provided on the substrate 3a.

The wiring 3d is drawn to the outside of the enclosure 1b via the hole provided on the wall surface of the enclosure 1b.

As described later, the other end portion of the wiring 3d is connected to a wiring 202 of an external power supply in the interior of the switch box 201.

The cover 4 is provided so as to cover the light emitting surface 2f side of the light-emitting unit 2.

The cover 4 is provided so as to close the opening of the depression 1a1.

In this case, the peripheral edge of the cover 4 may be bonded to the retaining portion 1a.

By bonding the peripheral edge of the cover 4 to the retaining portion 1a, the waterproof properties may be secured.

The cover 4 is formed of a material which transmits light radiated from the light-emitting unit 2.

The cover 4 may be formed of a resin material such as acrylic or an inorganic material such as glass.

In this case, the cover 4 may be formed of a transparent material or a colored material.

Subsequently, assembly of the luminaire 100 will be described.

The circuit component 3b is firstly mounted and the substrate 3a on which the wiring 3d and the wiring 5 are connected is inserted into the interior of the depression 1b1 from the opening of the depression 1a1.

At this time, the wiring 3d is drawn to the outside of the enclosure 1b via the hole provided on the wall surface of the enclosure 1b.

Subsequently, a filling nozzle is inserted from the opening of the depression 1a1 and the interior of the depression 1b1 is filled with silicone resin or the like to form the sealing portion 3c that seals the circuit component 3b mounted on the substrate 3a.

In this case, a portion where the wiring 3d is drawn is also filled with the silicone resin or the like.

Subsequently, the wiring 5 is connected to the light-emitting unit 2.

As another applicable method, the wiring 5 is connected to the light-emitting unit 2, then the substrate 3a is inserted into the interior of the depression 1b1 and then the sealing portion 3c is formed.

As still another applicable method, the substrate 3a is inserted into the interior of the depression 1b1, then the wiring 5 is connected to the light-emitting unit 2, and then the sealing portion 3c is formed.

Subsequently, the light-emitting unit 2 is retained in the interior of the depression 1a1.

In this case, for example, the end portions of the light-emitting unit 2 may be held therein tightly from both sides, may be tightened with screws, or may be bonded with an adhesive agent.

Subsequently, the cover 4 is mounted so as to close the opening of the depression 1a1.

In this case, for example the peripheral edge of the cover 4 may be bonded to the retaining portion 1a.

The luminaire 100 having a waterproof structure may be assembled as described above.

Subsequently, installation of the luminaire 100 will be described.

Fig. 3 is a schematic partial cross-sectional view illustrating about the installation of the luminaire 100 according to the first embodiment.

As illustrated in Fig. 3, the luminaire 100 is a recessed luminaire.

The switch box 201 is embedded into the interior of the building material 200.

The switch box 201 is opened to the surface 200a of the building material 200.

Although the type of the switch box 201 is not specifically limited, a metallic box for electric wires prescribed in JIS C8340 may be employed.

Although the switch box 201 is illustrated as an example, the switch box is not limited thereto.

Any suitable box embedded in the building material 200 and opened to the surface 200a of the building material 200 is applicable.

Although the switch box 201 illustrated in Fig. 3 is for a single use prescribed in JIS C8340, two or more of the switch boxes 201 may be used depending on the size of the luminaire 100.

The switch box 201 includes the space 201a in the interior thereof. In the interior of the space 201a, the wiring 3d of the luminaire 100 and the wiring 202 of the external power supply are connected. A connecting portion 202a between the wiring 3d and the wiring 202 is insulated.

The cross-sectional dimension of the space 201a parallel to the surface 200a of the building material 200 is larger than the cross-sectional dimension of an opening 201c parallel to the surface 200a of the building material 200.

The switch box 201 is provided with a mounting portion 201b projecting into the space 201a.

The mounting portion 201b is provided with a female thread configured to fasten a mounting fixture body 203, described later with a screw.

The female thread is located in the interior of the opening 201c of the switch box 201.

The mounting fixture body 203 has a frame shape, and is provided with a hole which allows the enclosure 1b of the housing 1 of the luminaire 100 to pass therethrough at the center thereof.

The mounting fixture body 203 is provided so as to surround the hole provided in the building material 200.

The mounting fixture body 203 is assembled to the surface 200a of the building material 200 in tight contact thereto via a packing 204 formed of rubber or the like.

The mounting fixture body 203 is assembled to the mounting portion 201b of the switch box 201 using a flat countersunk head screw 205 or the like.

The material of the mounting fixture body 203 is not specifically limited and, for example, a resin material or a metallic material may be used.

Amounting frame 206 is assembled to the mounting fixture body 203 with a screw, not shown.

The mounting frame 206 has a frame shape, and is configured to retain the light-emitting unit 2 of the luminaire 100 so as to hold the same tightly between the mounting frame 206 and the mounting fixture body 203.

When the luminaire 100 is assembled, the light-emitting unit 2 is exposed from the center of the mounting frame 206.

A packing 207 formed of rubber or the like is provided between the mounting frame 206 and the mounting fixture body 203.

Subsequently, installation of the luminaire 100 will be described.

First of all, the mounting fixture body 203 is assembled to the surface 200a of the building material 200 via the packing 204.

At this time, the mounting fixture body 203 is attached to the mounting portion 201b of the switch box 201 using the flat countersunk head screw 205 or the like.

Subsequently, the luminaire 100 is retained in the mounting fixture body 203 in such a manner that the enclosure 1b of the housing 1 of the luminaire 100 is put in the space 201a of the switch box 201.

In the interior of the space 201a of the switch box 201, the wiring 3d of the luminaire 100 and the wiring 202 of the external power supply are connected.

Subsequently, the mounting frame 206 is assembled to the mounting fixture body 203 via the packing 207.

The mounting frame 206 is assembled to the mounting fixture body 203 using the screw or the like, not shown. By mounting the mounting frame 206, the luminaire 100 is retained by being held tightly between the mounting frame 206 and the mounting fixture body 203.

In this manner, the installation of the luminaire 100 is achieved.

In the luminaire 100 according to the exemplary embodiment, the plate-shaped light-emitting unit 2 having the organic light-emitting diode and the control unit 3 provided on the side opposite the light emitting surface 2f of the plate-shaped light-emitting unit 2 are integrated. Therefore, the luminaire 100 having a small projecting dimension from the surface 200a of the building material 200 and the large light emitting surface 2f is provided.

For example, a projecting dimension H from the surface 200a of the building material 200 may be set to 15 mm or smaller.

Also, the thickness of the luminaire 100 may be reduced, and the depth of embedment into the building material 200 may be reduced.

Also, the appearance of the luminaire 100 may be improved.

Also, since the light-emitting unit 2 and the control unit 3 are integrated and the sealing structure is provided by filling a resin, improvement of the waterproof performances are achieved.

Also, since the installation using the mounting fixture body 203 and the mounting frame 206 is enabled, workability is improved.

Therefore, the luminaire 100 improved in the workability and the waterproof properties is provided.

### [Second Embodiment]

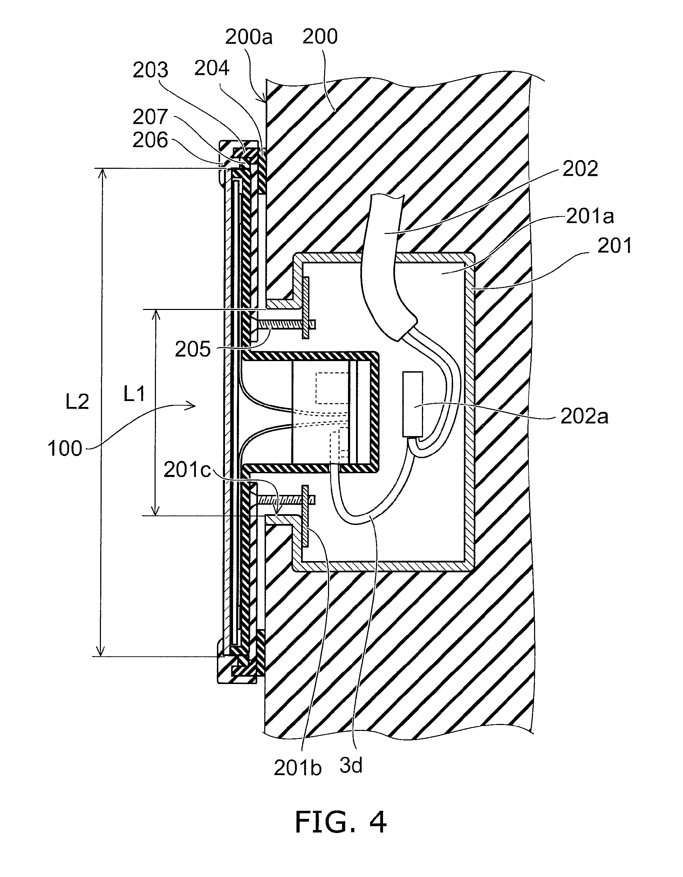

Fig. 4 is a schematic partial cross-sectional view illustrating about installation of the luminaire 100 according to a second embodiment.

As described above, the luminaire 100 is provided with the light-emitting unit 2 having the organic light-emitting diode.

Here, with the luminaire using the light-emitting diodes, it is necessary to arrange a number of light-emitting diodes and provide a light guide panel on an irradiating side of the number of light-emitting diodes. Therefore, the projecting dimension from the surface 200a of the building material 200 is increased.

In this case, if the light-emitting diode is provided in the space 201a of the switch box 201 to guide light from the light-emitting diode to the light guide panel provided on the surface 200a of the building material 200, there arises a problem that areas which are not lit may be generated on the light guide panel provided on the surface 200a of the building material 200.

In addition, if the light guide plate longer than an opening dimension L1 of the switch box 201 is employed, generation of the areas which are not lit become more apparent.

In other words, with the configuration in which the light-emitting diode is used as a light source, the luminaire configured in such a manner that the projecting dimension from the surface 200a of the building material 200 is small and the large light emitting surface 2f is provided may become difficult.

In contrast, the luminaire 100 is provided with the light-emitting unit 2 having the organic light-emitting diode which is the self-luminous element.

Therefore, even though a length L2 of the light-emitting unit 2 is longer than the opening dimension L1 of the switch box 201, the areas which are not lit are not generated on the light emitting surface 2f of the light-emitting unit 2.

Since the light-emitting unit 2 may be formed into a plate shape as described above, the projecting dimension from the surface 200a of the building material 200 may be reduced.

In other words, the luminaire 100 configured in such a manner that the projecting dimension from the surface 200a of the building material 200 is small, and the light emitting surface 2f is larger than the opening of the switch box 201 is provided.

In this case the size of the light emitting surface 2f of the light-emitting unit 2 is not limited by the size of the opening of the switch box 201 and arbitrary size is applicable.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions. Moreover, above-mentioned embodiments can be combined mutually and can be carried out.

## Claims

1. A luminaire (100) comprising:
a light-emitting unit (2) including an organic light-emitting diode;
a control unit (3) provided on a side opposite a light-emitting surface (2f) of the light-emitting unit (2) and configured to supply power to the light-emitting unit (2) ; and
a housing (1) configured to integrally cover (4) the light-emitting unit (2) and the control unit (3).

2. The luminaire (100) according to claim 1, wherein the light-emitting unit (2) is larger than an opening of a hole provided in a building material (200).

3. The luminaire (100) according to claim 1, wherein the housing (1) is provided in the interior of the hole provided in the building material (200).

4. The luminaire (100) according to claim 1, wherein the housing (1) seals up the light-emitting unit (2) and the control unit (3).

5. The luminaire (100) according to claim 1, wherein the housing (1) includes a hole that allows wiring (3d) connected to the control unit (3) to be drawn out, and
a gap between the hole that allows the wiring (3d) to be drawn out and the wiring (3d) is filled with a resin.

6. The luminaire (100) according to claim 1, wherein the housing (1) includes a retaining portion (1a) configured to retain the light-emitting unit (2) and an enclosure (1b) configured to accommodate the control unit (3).

7. The luminaire (100) according to claim 6, wherein the retaining portion (1a) includes a first depression (1a2) having an opening and is configured to retain the light-emitting unit (2) in the interior of the first depression (1a2).

8. The luminaire (100) according to claim 7, wherein the enclosure (1b) includes a second depression (1b1) configured to accommodate the control unit (3) and the second depression (1b1) opens to a bottom surface of the first depression (1a2).

9. The luminaire (100) according to claim 1, wherein the control unit (3) includes a substrate (3a), a circuit component (3b) mounted on the substrate (3a), and a sealing portion (3c) configured to seal the circuit component (3b) mounted on the substrate (3a).

10. The luminaire (100) according to claim 9, wherein the control unit (3) is retained in the interior of the housing (1) by the sealing portion (3c).

11. The luminaire (100) according to claim 9, wherein the control unit (3) is waterproofed by the sealing portion (3c).

12. The luminaire (100) according to claim 1, wherein the light-emitting unit (2) includes a first electrode layer (2b) having translucency, a second electrode layer (2d) having reflectivity, and a light-emitting layer (2c) provided between the first electrode layer (2b) and the second electrode layer (2d) and including an organic light-emitting material.

13. The luminaire (100) according to claim 1, further comprising:
a mounting fixture body (203) provided so as to surround the hole provided on the building material (200);
a mounting frame (206) to be assembled to the mounting fixture body (203), wherein
the light-emitting unit (2) is retained between the mounting fixture body (203) and the mounting frame (206).

14. The luminaire (100) according to claim 1 further comprising a cover (4) provided on the side of the light-emitting surface (2f) of the light-emitting unit (2).

15. The luminaire (100) according to claim 1, further comprising a box embedded in the building material (200) and opened to a surface (200a) of the building material (200).
